# EUROPÄISCHE PATENTSCHRIFT

(11) **EP 0 538 279 B1**
(45) Veröffentlichungstag und Bekanntmachung des Hinweises auf die Patenterteilung: **20.07.1994**
(21) Anmeldenummer: 91911272.2
(22) Anmeldetag: 27.06.1991
(51) Int. Cl.: H01L 21/306, H01L 21/76

(54) **VERFAHREN ZUM DÜNNÄTZEN VON SUBSTRATEN**
PROCESS FOR THE THIN ETCHING OF SUBSTRATES
PROCEDE D'AMINCISSEMENT DE SUBSTRATS PAR CORROSION

(30) Priorität: 06.07.1990 DE 4021541
(43) Veröffentlichungstag der Anmeldung: 28.04.1993
(73) Patentinhaber: FRAUNHOFER-GESELLSCHAFT ZUR FÖRDERUNG DER ANGEWANDTEN FORSCHUNG E.V., 80636 München (DE)
(72) Erfinder: HABERGER, Karl, D-8033 Planegg (DE); BUCHNER, Reinhold, D-8000 München 80 (DE); BOLLMANN, Dieter, D-8000 München 70 (DE)
(74) Vertreter: Schoppe, Fritz, Dipl.-Ing.
(86) Internationale Anmeldenummer: DE9100535
(87) Internationale Veröffentlichungsnummer: WO9201309

(56) Entgegenhaltungen:
- US-A- 3 830 665
- IBM TECHNICAL DISCLOSURE BULLETIN, vol. 23, no. 3, August 1980, New York, US, pages 1260-1261 ; Fr. T. Hodgson : "Method of etching undoped regions of a substrate without masking".
- APPLIED PHYSICS A. SOLIDS AND SURFACES, vol. A37, no. 2, June 1985, Heidelberg, DE, pages 117-119 ; F. V. Bunkin et al. : "Si Etching Affected by IR Laser Irradiation".
- PATENT ABSTRACTS OF JAPAN, vol. 14, no. 205 (E-291)(4148) 26 April 1990 ; & JP-A-02 044 728
- JAPANESE JOURNAL OF APPLIED PHYSICS, vol. 28, no. N08, August 1989, Tokyo, JP, pages 1426-1443 ; J. Haisma et al. : "Silicon-on-Insulator Wafer Bonding-Wafer Thinning Technological Evaluations".

## Beschreibung

Die vorliegende Erfindung betrifft ein Verfahren zum Dünnätzen von mittels chemischen Ätzmitteln ätzbaren Substraten auf eine wenigstens bereichsweise gleiche, vorbestimmbare Substratschichtdicke.

Allgemein befaßt sich die Erfindung mit einem Verfahren zum Herstellen extrem dünner Substrate oder extrem dünner Substratschichten mit Schichtdicken in der Größenordnung von weniger als einem Mikrometer.

Bei der Entwicklung und Fertigung hochintegrierter Schaltungen wurden in den letzten Jahren zunehmend Techniken zur gegenseitigen lateralen Isolation der einzelnen, planar auf der Halbleiteroberfläche angeordneten Bauelemente eingesetzt, um den gegenseitigen Abstand der Einzelbauelemente zu vermindern und somit die Integrationsdichte der integrierten Schaltung zu erhöhen. Typische Isolationstechniken für die gegenseitige laterale Isolation von Halbleiterbauelementen innerhalb von Halbleiterschaltungen sind dem Fachmann unter den Begriffen LOCOS sowie Trench-Ätztechnik bekannt.

Der Grund für den Einsatz lateraler Isolationstechniken liegt darin, daß elektrisch relevante Vorgänge in Halbleiterschaltungen typischerweise in einem etwa 1 µm dicken, obersten Schichtbereich des Halbleiterkristalles ablaufen. Aus mechanischen Gründen ist es üblicherweise erforderlich, daß der Halbleiterkristall viele 100 µm dick sein muß. Abgesehen von seiner mechanischen Trägerfunktion erweist sich das dicke Halbleiterkristallmaterial als bezüglich seiner elektrischen Eigenschaften nachteilig. Gegenüber derartig dicken Halbleiterkristallen haben dünne Substrate einige technologische Vorteile, die die verglichen mit dickeren Materialien einfachere laterale Isolation, durch die bei CMOS-Schaltungen ein latch-up-Effekt unterdrückt werden kann, sowie das Fehlen von ausgedehnten Raumladungszonen umfassen.

Die Vorteile solcher dünner Substrate versucht man seit längerer Zeit durch verschiedenartige Technologien auszunutzen, bei denen jeweils eine dünne Halbleiterschicht oder Nutzschicht oberhalb einer Isolationsschicht angeordnet ist, die ihrerseits auf einem Trägersubstrat liegt.

Eine dieser Technologien ist die sogenannte SOS (Silicon on Sapphire)-Technik, bei der eine Siliziumschicht heteroepitaktisch auf einen Saphirkristall aufgewachsen wird. Mit dieser Technologie können jedoch lediglich Siliziumschichten von schlechter Kristallqualität erzeugt werden.

Bei der SIMOX (Silicon implanted Oxygen)-Technologie wird Sauerstoff in hohen Dosen in Silizium implantiert und bildet nach einem Temperaturschritt in einer Entfernung von ungefähr 0,2 µm unter der Halbleiteroberfläche eine vergrabene, isolierende SiO₂-Schicht. Bei diesem Verfahren zum Erzeugen der vergrabenen isolierenden Schicht entstehen jedoch Kristallschäden.

Die oben angesprochenen Techniken umfassen ferner die sogenannte ZMR (Zone Melting Recrystallization)-Technologie. Hierbei wird auf einem oxidierten Wafer zunächst eine amorphe oder mikrokristalline Siliziumschicht abgeschieden. Mittels Laserstrahlen oder Elektronenstrahlen wird die amorphe Siliziumschicht in ihrem Oberflächenbereich umgeschmolzen, um große Kristallbereiche zu erzeugen. Jedoch ist es bei dieser Technik nicht möglich, die gesamte erneut kristallisierte Schicht als Einkristall von hoher Qualität auszubilden.

Ein vielversprechender Weg zum Erzeugen der oben angesprochenen SOI-Substrate, bei denen die Halbleiterschicht oberhalb einer isolierenden Schicht liegt, ist die Wafer-Bonding-Technologie, da durch diese Technologie prinzipiell perfekt monokristalline Nutzschichten erzeugt werden können. Hierbei werden zwei Wafer unter extrem staubfreien Bedingungen mit ihren polierten Oberflächen zusammengebracht. In der Regel sind ein oder beide Wafer mit einer Siliziumdioxidschicht versehen, die durch thermische Oxidation oder Abscheiden einer Oxidschicht erzeugt wird. Diese Oxidschicht kann auch dotiert sein und beispielsweise Bor-Silikatglas, Phosphorsilikatglas oder Bor-Phosphor-Silikatglas umfassen. Ebenfalls können andere, isolierende und chemisch resistente Materialien für die Isolationsschicht verwendet werden.

Auch können ein Wafer oder beide Wafer bereits Strukturen bis hin zu fertigen Bauelementen enthalten. Die Oberfläche der Wafer kann mit einem Isolator, wie beispielsweise Siliziumdioxid, bedeckt sein oder unter Anwendung eines der an sich bekannten Planarisierungsverfahren, das die Verwendung von Fließgläsern und Spin-On-Gläsern und das Rückätzen umfaßt, eingeebnet worden sein.

Die Haftung zwischen den beiden Waferflächen beruht zunächst auf der Ausbildung von Wasserstoffbrücken zwischen adsorbierten OH-Gruppen. Bei der anschließenden Erwärmung der Wafer bilden sich bei etwa 300 °C Si-O-Si-Bindungen aus, wobei schließlich bei Temperaturen um 1000 °C durch einen viskosen Fluß des Oxids eine feste, von einem gewachsenen Oxid nicht unterscheidbare Verbindung eintritt. Nach dem so durchgeführten Bonden der beiden Wafer können die gebondeten Wafer einseitig gedünnt werden, so daß die dünne SOI-Nutzschicht unlösbar gebondet mit dem Trägerwafer zurückbleibt.

Das technologische Hauptproblem liegt hier im Dünnen der Nutzschicht des gebondeten Wafers, da Schichtdicken der Nutzschicht von bis herab zu 0,1 µm angestrebt werden. Das Dünnen erfolgt zunächst mechanisch durch Schleifen und im letzten Stadium des Dünnens durch eine naßchemische Behandlung. Das Problem liegt hierbei in der Gleichförmigkeit des Dünnungsprozesses, durch die natürlich die letztendlich nicht unterschreitbare Restdicke der Nutzschicht festgelegt wird.

Zu diesem Zweck wird in der Fachveröffentlichung J.B. Lasky, S.R. Stiffler, F.R. White und J.R. Abernathy, IEDM Techn. Dipl. 684 (1985), vorgeschlagen, eine hochdotierte (Bor-p⁺)-Schicht zu implantieren oder einzudiffundieren, die bei dem naßchemischen Ätzen zum Dünnen der Nutzschicht als Ätzstop dient, wobei man zum Erzielen von hochohmigen Nutzschichten auf der Ätzstopschicht noch eine niedrigdotierte Epischicht aufbringt. Die implantierte Ätzstopschicht hat zwar eine über die Oberfläche des Halbleiters konstante Tiefe, durch die eine konstante Dicke der Nutzschicht im Sub-MikrometerBereich garantiert werden kann. Jedoch entstehen bei der Implantation der Ätzstopschicht und der Epitaxie Kristallschäden oder es tritt ein Dotieren durch Autodoping auf. Ferner erfordert diese Technik einen hohen Fertigungsaufwand und damit zusätzliche Kosten.

In der Fachveröffentlichung T. Matsushita, H. Satoh, M. Shi-manoe, A. Nieda, A. Ogasawara, M. Yamagishi, A. Yagi, 47. th Annual Device Research Conference, Juni 1989, Cambridge, Mass., wird ein anderes Verfahren zum definierten flächenhomogenen Dünnen der Nutzschicht angegeben. Hierbei werden photolithographisch erzeugte, teilweise vergrabene Stützgitter aus Hartstoffen, wie beispielsweise SiO₂ oder Si₃N₄ verwendet, um bei dem mechanischen Schleifen eine gleichmäßige Schichtdicke der Nutzschicht zu gewährleisten. Mit diesem Verfahren wurden SOI-Schichten mit einer Schichtdicke von 80 nm +/- 20 nm über die Schichtdicke eines 5-Inch-Wafers erzielt. Durch das Stützgitter ist es jedoch nicht möglich, eine perfekt monokristalline Halbleiternutzschicht über die gesamte Waferfläche zu erhalten.

Aus der Fachveröffentlichung A. Yamada, B.L. Jiang, H. Shi-rotori, O. Okabayaski, T. Iizuka, G.A. Rozgonyi, Elektro-chemical Society Spring Meeting, Vol. 90, Seite 458, ist es bekannt, das Dünnen der Nutzschicht durch elektrochemisches und numerisch gesteuertes Polieren vorzunehmen. Dieses Verfahren ist aufgrund des hohen apparativen Aufwandes für die Praxis kaum einsetzbar.

Es ist bekannt, die Schichtdicke einer zu ätzenden Schicht während des Ätzvorganges mittels Licht zu überwachen, wobei der Ätzvorgang beendet wird, sobald die zu ätzende Schicht für das Überwachungslicht durchsichtig ist.

Aus der BP-A-2 044 728 (Abstract) ist es bekannt, zur Steigerung der Ätzgeschwindigkeit eines isolierenden Filmes auf einer Metallschicht die aus dem isolierenden Film und der Metallschicht bestehende Struktur mit Infrarotstrahlung zu bestrahlen. Die Infrarotstrahlung wird durch Metallschichtbereiche reflektiert. Die reflektierte Strahlung erfährt innerhalb des isolierenden Filmes oberhalb der Metallschichtbereiche eine stärkere Absorption als außerhalb der Metallschichtbereiche, so daß es zu einer stärkeren Ätzrate des isolierenden Filmes oberhalb der Metallschichtbereiche kommt. Diese Technik dient ausschließlich dazu, die Ätzgeschwindigkeit für das Abätzen isolierender Bereiche oberhalb eines Metallschichtbereiches verglichen mit der Ätzgeschwindigkeit von isolierenden Bereichen, die nicht oberhalb von Metallschichtbereichen liegen, anzuheben, um dadurch Erhöhungen der isolierenden Schicht oberhalb der Metallschichtbereiche verstärkt abzutragen. Dies soll zu einer Reduktion der topographischen Stufen führen, die der isolierende Film aufgrund der darunterliegenden Metallschichtbereiche hat. Diese Schrift befaßt sich somit nicht mit der Problematik der Erzeugung von bereichsweise gleichen, vorbestimmbaren Substratschichtdicken.

Aus der Fachveröffentlichung IBM TDB, Band 23, Nr. 3, August 1980, Seiten 1260 und 1261 ist ein Ätzverfahren zum maskenfreien Ätzen von undotierten Bereichen eines Substrates bekannt. Bei diesem Verfahren bedient man sich der verstärkten Absorption von Laserlicht entweder in dotierten oder in undotierten Bereichen eines Halbleitersubstrates während des Ätzvorganges, um dadurch die Ätzrate innerhalb des jeweils stärker absorbierenden Bereiches zu erhöhen. Mit der Erzeugung von ungestörten Schichten von zumindest bereichsweise gleicher, vorbestimmbarer Schichtdicke befaßt sich diese Schrift nicht.

Ausgehend von diesem Stand der Technik liegt der vorliegenden Erfindung die Aufgabe zugrunde, ein Verfahren zum Dünnätzen von mittels chemischen Ätzmitteln ätzbaren Substraten auf eine wenigstens bereichsweise gleiche, vorbestimmbare Substratschichtdicke anzugeben, das lediglich einen niedrigen Aufwand erfordert und bei dem ferner Störungen innerhalb der Substratschicht vermieden werden.

Diese Aufgabe wird erfindungsgemäß durch ein Verfahren gemäß Patentanspruch 1 gelöst.

Der Erfindung liegt die Erkenntnis zugrunde, daß durch Bestrahlung des Substrates während des Ätzvorganges mittels einer Strahlungsquelle mit einer im wesentlichen senkrecht auf die Substratoberfläche einfallenden Strahlung bei Substraten aus solchen Materialen, die die verwendete Strahlung absorbieren, eine von der momentanen Restschichtdicke bezogen auf die Absorptionslänge der Strahlung abhängige Erwärmung der Substratschicht auftritt. Da die Ätzrate bei praktisch allen chemischen Ätzen stark temperaturabhängig ist, ist die erzielte Ätzrate abhängig von der Erwärmung der Substratschichtdicke, die schichtdickenabhängig ist. Sobald die verbleibende Substratschichtdicke die Absorptionslänge der Strahlung der verwendeten Wellenlänge in dem Substratmaterial unterschreitet, läßt die Erwärmung aufgrund der Strahlung nach, da der absorbierte Anteil der Strahlung nachläßt. Durch Variation der Wellenlänge der verwendeten Strahlung im Falle einer einfrequenten Strahlung bzw. eines monochromatischen Lichtes bzw. durch Variation des Hauptspektrums der verwendeten Strahlung, zum Beispiel im Falle eines Strahlers mit einem breiten Strahlungsspektrum, kann die Absorptionslänge der Strahlung in dem Substratmaterial eingestellt werden. Unter der Absorptionslänge wird diejenige Eindringtiefe verstanden, innerhalb der die Reststrahlung bezogen auf die eingetretene Strahlung um den Faktor 1 geteilt durch e abgefallen ist. Die Absorptionslänge wird so gewählt, daß sie größer als die gewünschte Substratschichtdicke ist. Damit kann durch Wahl der Strahlung die erzielbare Substratschichtdicke im wesentlichen frei eingestellt werden.

Nachfolgend wird eine bevorzugte Ausführungsform des erfindungsgemäßen Verfahrens näher erläutert. Bei dem bevorzugten Verfahren nach der vorliegenden Erfindung wird zunächst ein Wafer-Bonding-SOI-Substrat in einer im Stand der Technik an sich bekannten Art hergestellt, die oben bereits erläutert wurde. Bei der bevorzugten Ausführungsform werden zwei Siliziumwafer an ihre Oberfläche durch thermische Oxidation mit einer Siliziumdioxidschicht versehen. Nach Polieren der Waferoberflächen werden **die** **Wafer** unter extremen staubfreien Bedingungen mit ihren polierten Oberflächen zusammengefügt. Anschließend werden die zusammengefügten Wafer auf Temperaturen zwischen etwa 300 °C und etwa 1000 °C erwärmt. Bei Temperaturen von etwa 300 °C bilden sich Si-O-Si-Bindungen aus, während bei einer Erwärmung auf Temperaturen um ungefähr 1000 °C ein viskoser Fluß des Oxids zu einer festen, von einem gewachsenen Oxid nicht unterscheidbaren Verbindung führt.

Nunmehr wird die Siliziumschicht des Nutzwafers mittels an sich bekannter mechanischer Verfahren auf eine Restdicke von etwa 10 - 20 µm mechanisch gedünnt. Das mechanische Dünnen kann beispielsweise durch Schleifen erfolgen.

Dieser erste Dünnprozess kann auch durch ein naßchemisches Ätzen erfolgen. Gleichfalls ist es denkbar, bei geeignet dünnen Nutzwafern auf einen derartigen ersten Dünnprozess vollständig zu verzichten.

Das Wafer-Bonding-Substrat wird nun auf eine Ansaughaltevorrichtung aufgebracht und gegenüber dieser z.B. mittels Unterdruck festgelegt, sodaß ein guter thermischer Kontakt entsteht. Die Ansaughaltevorrichtung wird zusammen mit dem Substrat in ein Ätzbad eingebracht. Dieses kann beispielsweise eine verdünnte Kalilauge sein.

In dieses Ätzbad wird von einer Strahlungsquelle eine Strahlung derart eingestrahlt, daß sie im wesentlichen senkrecht auf die Substratoberfläche des Nutzwafers einfällt. Unter dem Begriff "im wesentlichen senkrecht" sei im Sinne der Terminologie der vorliegenden Anmeldung verstanden, daß die Strahlung in einem solchen Winkel auf die Substratoberfläche einfällt, daß sie in diese eindringt. In der Regel wird man bemüht sein, die Strahlung senkrecht auf die Oberfläche des Nutzwafers auftreffen zu lassen.

Bei dem bevorzugten beispielhaften Verfahren ist die Strahlungsquelle ein Argonlaser, der Licht mit einer Leistungsdichte von etwa 100 W/cm² abgibt.

Das von einem Argonlaser abgegebene monochromatische Licht liegt im sichtbaren Bereich und hat eine Wellenlänge, die der Farbe Grün entspricht.

Anstelle eines monochromatischen Lichts kann auch ein Licht oder eine andere elektromagnetische Strahlung mit einem verteilten Frequenzspektrum verwendet werden.

Die Wellenlänge des Hauptanteiles der Strahlung wird derart gewählt, daß die Absorptionlänge der Strahlung bei dieser Wellenlänge in dem Substratmaterial, das im Ausführungsbeispiel Silizium ist, größer ist als die gewünschte Substratschichtdicke.

Da die gewünschte Schichtdicke der Nutzschicht bei dem bevorzugten Ausführungsbeispiel 0,2 µm beträgt, wurde als Strahlungsquelle der Argonlaser mit der Wellenlänge von λ = 0,512 µm gewählt, da Licht von dieser Wellenlänge in Silizium eine Absorptionslänge von etwa 0,3 - 0,5 µm hat.

Solange nun die Dicke der Nutzschicht des bestrahlten Wafer-Bonding-SOI-Substrates oberhalb von etwa 0,3 µm liegt, führt das absorbierte Licht zu einer Temperaturerhöhung der Nutzschicht, welche sich gegenüber dem Bonding-Oxid etwa proportional zu der absorbierten Leistung und etwa proportional zu der Oxiddicke sowie etwa umgekehrt proportional zu der Wärmeleitfähigkeit des Oxids erwärmt. Die Wärmeleitfähigkeit von Siliziumdioxid liegt etwa um den Faktor 10 unter derjenigen von Silizium bei Raumtemperatur.

Die sich einstellende Temperaturerhöhung der SOI-Nutzschicht liegt je nach der eingestrahlten Leistung zwischen 10 und 100 °C. Die Ätzrate praktisch aller chemischen Ätzmittel ist stark temperaturabhängig. Da das KOH-Si-System eine Aktivierungsenergie von etwa 0,6 eV hat, führt eine Temperaturerhöhung von 25 °C zu einer Erhöhung der Ätzrate um etwa den Faktor 10.

Infolgedessen nimmt die Ätzrate der Nutzschicht stark ab, sobald deren Dicke unter die Absorptionslänge der verwendeten Lichtstrahlung abfällt. Sobald die Nutzschicht eine Dicke von ungefähr 0,2 µm erreicht hat, läßt sie das einfallende Argonlaserlicht praktisch vollständig durch, so daß dessen Energie von dem Trägerwafer absorbiert wird und ohne nennenswerte Temperaturerhöhung desselben aufgrund der hohen Wärmeleitfähigkeit des Siliziums zu der Ansaughaltevorrichtung abgeleitet wird.
In praktischen Versuchen konnte nachgewiesen werden, daß eine Nutzschichtdicke von 0,2 µm über die Gesamtfläche eines 6-Inch-Wafers bei hoher Nutzschichtdickenkonstanz erzielbar ist.

Für den Fachmann ist es offenkundig, daß der Verlauf des Ätzprozesses durch geeignete Parameterwahl steuerbar ist, wobei zu diesem Parametern in erster Linie die Strahlungswellenlänge und Strahlungsleistungsdichte, die Ätzmittelzusammensetzung und die Grundtemperatur zählen.

Bei Verwendung von lokalen Lichtquellen oder Punktlichtquellen erlaubt das erfindungsgemäße Verfahren eine Bestrahlung unterschiedlicher Waferbereiche mit unterschiedlichen Wellenlängen und Leistungsdichten, wodurch Gebiete mit unterschiedlicher, aber über das Gebiet konstanter Dicke erzeugbar sind.

Daher ermöglicht das erfindungsgemäße Verfahren die Herstellung von Halbleiterstrukturen mit Nutzschichtbereichen unterschiedlicher Dicke, wobei die jeweilige Dicke optimal auf den jeweiligen Anwendungszweck der Nutzschicht abgestimmt werden kann. Besondere Bedeutung hat dies beispielsweise bei integrierten Schaltungen, die einerseits Hochspannungsbauelemente umfassen, welche dicke Substratstärken benötigen, und andererseits Ansteuerlogiken haben, bei denen eine dünne Substratstärke ausreicht. Das erfindungsgemäße Verfahren kann beispielsweise auch bei integrierten Sensoren oder mikromechanischen Bauelementen eingesetzt werden, die Logikschaltungen oder Verstärkerschaltungen aufweisen und beispielsweise dünne, freitragende Halbleitermembranen umfassen.

In Abweichung von dem beschriebenen, bevorzugten Ausführungsbeispiel können mittels des erfindungsgemäßen Verfahrens auch Bonding-Wafer gedünnt werden, deren Trägersubstrat beispielsweise aus einem bei der Wellenlänge des sichtbaren Lichtes durchsichtigen Material besteht, wofür zum Beispiel Quarzglas oder Saphir herangezogen werden kann. Allgemein kann das Trägersubstrat aus einem die Strahlung nicht oder nur geringfügig absorbierenden Material bestehen. Diese Ausgestaltung des Trägers führt zu einer besonders niedrigen Leistungsaufnahme durch diesen, wodurch in erwünschter Weise die Temperaturdifferenzen zwischen zu ätzenden Bereichen von noch unterschiedlicher Dicke der Nutzschicht verstärkt werden, so daß es zu einer verbesserten Kontinuität der erzielbaren Nutzschichtdicke kommt.

In weiterer Abweichung von dem beschriebenen Ausführungsbeispiel kann das erfindungsgemäße Verfahren auch bei anderen Halbleitermaterialien, Metallen und dielektrischen Schichten eingesetzt werden, soweit das zu ätzende Material Strahlungen über eine bestimmte Absorptionslänge absorbiert.

Anstelle des bei dem bevorzugten Ausführungsbeispiel eingesetzen Argonlasers kann als Lichtquelle ein gepulster Strahler dienen, der beispielsweise eine Blitzlichtlampe sein kann. Gleichfalls kommt als Lichtquelle ein thermischer Strahler in Betracht, der gegebenenfalls mit Filtern versehen ist. Nur beispielsweise sei hier eine Glühfadenlampe oder eine Gasentladungslampe genannt. Auch ist es möglich, eine Blitzlichtlampe zu verwenden, die dynamische Temperaturerhöhungen bewirkt.

Zur Einstellung der Ätzgeschwindigkeit kann auch innerhalb des Verfahren die Zusammensetzung des Ätzmittels variert werden. Anstelle der bei dem bevorzugten Ausführungsbeispiel verwendeten flüssigen Ätzlösung kann auch ein Ätzgas oder ein Ätzgasgemisch verwendet werden.

Zur weiteren Vergleichmäßigung des Ätzverfahrens kann die Strahlungsquelle gegenüber dem zu ätzenden Substrat bewegt werden. Obwohl es ausreichend ist, die Wellenlänge des Strahlers derart zu wählen, daß die Absorptionslänge dieser Strahlung innerhalb des zu ätzenden Materiales größer ist als die zu erzielende Schichtdicke, wird ein besonders einfaches Einstellen der Schichtdicke und ein besonders stabiler Ätzstop dann erreicht, wenn die Absorptionslänge der Strahlung mit der gewählten Wellenlänge um den Faktor 3 bis 8 oberhalb der gewünschten Schichtdicke liegt.

## Patentansprüche

1. Verfahren zum Dünnätzen von mittels chemischen Ätzmitteln ätzbaren Substraten auf eine vorbestimmbare Substratschichtdicke,
bei dem das Substrat zur schichtdickenabhängigen Steuerung der Ätzgeschwindigkeit mittels einer Strahlungsquelle mit einer im wesentlichen senkrecht auf die Substratoberfläche einfallenden Strahlung bestrahlt wird,
bei dem das Substrat aus einem die Strahlung absorbierenden Material besteht, und
bei dem die Wellenlänge des Hauptanteiles der Strahlung so gewählt ist, daß die Absorptionslänge der Strahlung dieser Wellenlänge in dem Substratmaterial größer als die gewünschte Substratschichtdicke ist, so daß das Substrat, solange es eine größere Dicke als die gewünschte Schichtdicke hat, durch hohe Strahlungsabsorption zunächst relativ stark thermisch angeregt wird und damit mit hoher Ätzgeschwindigkeit abgeätzt wird, während die Strahlungsabsorption bei Erreichen der gewünschten Schichtdicke abnimmt, wodurch die thermische Anregung vermindert wird und ein Ätzstopp erfolgt.

2. Verfahren nach Anspruch 1,
bei dem das dünnzuätzende Substrat die Nutzschicht eines Wafer-Bonding-SOI-Substrates ist, welches eine Trägerschicht, eine auf dieser angeordnete Isolatorschicht und eine auf letzterer angeordnete Nutzschicht aufweist.

3. Verfahren nach Anspruch 2,
bei dem die Trägerschicht aus einem Halbleitermaterial besteht.

4. Verfahren nach Anspruch 2,
bei dem die Trägerschicht aus einem die Strahlung nicht oder nur geringfügig absorbierenden Material besteht.

5. Verfahren nach Anspruch 4,
bei dem die Trägerschicht aus einem im sichtbaren Wellenlängenbereich durchsichtigen Material besteht.

6. Verfahren nach Anspruch 5,
bei dem die Trägerschicht aus Quarzglas besteht.

7. Verfahren nach einem der Ansprüche 1 - 6,
bei dem die Absorptionslänge um den Faktor 3 bis 8 oberhalb der gewünschten Substratschichtdicke liegt.

8. Verfahren nach einem der Ansprüche 1 - 7,
bei dem die Strahlung monochromatisches Licht ist.

9. Verfahren nach einem der Ansprüche 1 - 7,
bei dem die Strahlung eine thermische, nicht-monochromatische Strahlung ist.

10. Verfahren nach einem der Ansprüche 1 - 9,
bei dem die Strahlungsquelle unterschiedliche Bereiche des Substrates mit Strahlung von unterschiedlicher Wellenlänge und/oder unterschiedlicher Leistungsdichte bestrahlt, um über das Substrat definiert veränderbare, unterschiedliche Substratschichtdicken zu erzeugen.

11. Verfahren nach einem der Ansprüche 1 - 10,
bei dem unterschiedliche Bereiche des Substrats sequentiell mit Licht von unterschiedlicher Wellenlänge bestrahlt werden, wobei jeder Bereich nur mit Licht einer Wellenlänge bestrahlt wird, so daß eine durch die Wellenlänge festgelegte, lokale Dicke der Substratschicht erreicht wird.

12. Verfahren nach einem der Ansprüche 1 - 11,
bei dem das Ätzmittel flüssig oder gasförmig ist.

## Claims

1. A process for the thin-etching of substrates which are adapted to be etched by chemical etching agents to a predeterminable substrate layer thickness,
wherein the substrate is irradiated by means of a radiation source whose radiation impinges substantially perpendicularly to the substrate surface etching effect a layer thickness-dependent control of the etching rate,
wherein the substrate consists of a material absorbing the radiation, and
wherein the wavelength of the main component of the radiation is chosen such that the absorption length of the radiation of this wavelength in the substrate material will be greater than the desired substrate layer thickness so that the substrate, as long as its thickness is greater than the desired layer thickness, will first be subjected to a comparatively strong thermal excitation due to high radiation absorption and will thus be etched away at a high etching rate, whereas the radiation absorption will decrease when the desired layer thickness has been obtained, whereby the thermal excitation will be reduced and etching will be stopped.

2. A process according to claim 1,
wherein the substrate to be thinned by etching is the usable layer of a wafer-bonding-SOI substrate, which comprises a carrier layer, an insulating layer arranged on said carrier layer and a usable layer arranged on said insulating layer.

3. A process according to claim 2,
wherein the carrier layer consists of a semiconductor material.

4. A process according to claim 2,
wherein the carrier layer consists of a material which does not absorb the radiation, or which absorbs the radiation only to a minor extent.

5. A process according to claim 4,
wherein the carrier layer consists of a material which is transparent in the visible wavelength region.

6. A process according to claim 5,
wherein the carrier layer consists of quartz glass.

7. A process according to one of the claims 1 to 6,
wherein the absorption length is greater than the desired substrate layer thickness by a factor of 3 to 8.

8. A process according to one of the claims 1 to 7,
wherein the radiation is monochromatic light.

9. A process according to one of the claims 1 to 7,
wherein the radiation is a thermal, non-monochromatic radiation.

10. A process according to one of the claims 1 to 9,
wherein the radiation source irradiates different areas of the substrate with radiations of different wavelengths and/or different power densities so as to produce over the substrate different substrate layer thicknesses which are adapted to be varied in a defined manner.

11. A process according to one of the claims 1 to 10,
wherein different areas of the substrate are irradiated sequentially with light of different wavelengths, each area being irradiated only with light of one wavelength so that a local thickness of the substrate layer determined by the wavelength will be achieved.

12. A process according to one of the claims 1 to 11,
wherein the etching agent is liquid or gaseous.

## Revendications

1. Procédé d'amincissement à une épaisseur de couche de substrat prédéterminée de substrats corrodables à l'aide de décapants chimiques,
dans lequel le substrat est irradié, à l'aide d'une source de rayonnement, par un rayonnement incident sensiblement perpendiculaire à la surface du substrat, en vue du réglage de la vitesse de corrosion en fonction de l'épaisseur de couche,
dans lequel le substrat est en un matériau absorbant le rayonnement, et
dans lequel la longueur d'onde de la partie principale du rayonnement est choisie de telle manière que la longueur d'absorption du rayonnement de cette longueur d'onde dans le matériau du substrat est supérieure à l'épaisseur de couche de substrat souhaitée, de sorte que le substrat, tant qu'il a une épaisseur supérieure à l'épaisseur de couche souhaitée, est, par une grande absorption du rayonnement, tout d'abord soumis à une excitation thermique relativement grande et donc corrodé à grande vitesse de corrosion, tandis que l'absorption du rayonnement diminue lorsque l'épaisseur de couche souhaitée est atteinte, d'où l'excitation thermique diminue et un arrêt de corrosion a lieu.

2. Procédé suivant la revendication 1, dans lequel le substrat à amincir est la couche utile d'un substrat SOI à couches liées qui présente une couche de support, une couche isolante disposée sur celle-ci et une couche utile disposée sur cette dernière.

3. Procédé suivant la revendication 2, dans lequel la couche de support est en un matériau semi-conducteur.

4. Procédé suivant la revendication 2, dans lequel la couche de support est en un matériau n'absorbant pas ou que peu le rayonnement.

5. Procédé suivant la revendication 4, dans lequel la couche de support est en un matériau transparent dans la plage de longueur d'onde visible.

6. Procédé suivant la revendication 5, dans lequel la couche de support est en verre de quartz.

7. Procédé suivant l'une des revendications 1 à 6, dans lequel la longueur d'absorption se situe d'un facteur de 3 à 8 au-dessus de l'épaisseur de couche de substrat souhaitée.

8. Procédé suivant l'une des revendications 1 à 7, dans lequel le rayonnement est de la lumière monochromatique.

9. Procédé suivant l'une des revendications 1 à 7, dans lequel le rayonnement est un rayonnement thermique non-monochromatique.

10. Procédé suivant l'une des revendications 1 à 9, dans lequel la source de rayonnement irradie différentes zones du substrat d'un rayonnement de longueur d'onde différente et/ou d'intensité différente, afin de produire sur le substrat différentes épaisseurs de couche de substrat variables de manière définie.

11. Procédé suivant l'une des revendications 1 à 10, dans lequel différentes zones du substrat sont irradiées séquentiellement par une lumière de longueur d'onde différente, chaque zone n'étant irradiée que par de la lumière d'une seule longueur d'onde, de manière qu'il est obtenu une épaisseur locale de la couche de substrat déterminée par la longueur d'onde.

12. Procédé suivant l'une des revendications 1 à 11, dans lequel le décapant est liquide ou gazeux.
